# EUROPEAN PATENT APPLICATION

(11) **EP 2 636 765 A1**
(43) Date of publication of application: **11.09.2013**
(21) Application number: 13157093.9
(22) Date of filing: 27.02.2013
(51) Int. Cl.: C23C 14/24, C23C 14/16

(54) **Methods for vapor depositing high temperature coatings on gas turbine engine components utilizing pre-alloyed pucks**

(30) Priority: 07.03.2012 US 201213413783
(71) Applicant: Honeywell International Inc., Morristown, NJ 07962-2245 (US)
(72) Inventor: Ernst, Michelle, Morristown, NJ New Jersey 07962-2245 (US); Marszal, Dean, Morristown, NJ New Jersey 07962-2245 (US); Mravcak, Paul, Morristown, NJ New Jersey 07962-2245 (US); Knoch, Fred, Morristown, NJ New Jersey 07962-2245 (US); Viguie, Rudolfo, Morristown, NJ New Jersey 07962-2245 (US)
(74) Representative: Houghton, Mark Phillip

(57) **Abstract**

Methods for vapor depositing high temperature coatings on gas turbine components are provided, as are methods for producing pre-alloyed pucks for usage in vapor deposition processes. In one embodiment, the method (10) includes the step of producing (14) a pre-alloyed puck including a master alloy and a high vaporization temperature refractory metal, which has a vaporization temperature greater than each of the master alloy constituents. The pre-alloyed puck is placed (16) over an ingot and heated (22) to a temperature greater than the melt point of the pre-alloyed puck and less than the vaporization temperature of the high vaporization temperature refractory metal to transform the puck and a portion of the ingot into a molten pool and to produce a vapor stream containing the constituents of the master alloy and the ingot. The vapor stream is exposed (22) to a gas turbine engine component to deposit the high temperature coating over at least one surface thereof.

## Description

### TECHNICAL FIELD

The present invention relates generally to gas turbine engine components and, more particularly, to improved vapor deposition methods for the formation of high temperature coatings on gas turbine engine components.

### BACKGROUND

The maximum operating temperature of a gas turbine engine is generally limited by the ability of hot section components (e.g., combustor liners, turbine seals, turbine blades, compressor blades, nozzle guide vanes, duct members, and the like) to withstand direct exposure to combustive gas flow without excessive structural degradation due to hot corrosion, oxidation, thermal fatigue, erosion, and the like. Advances in high temperature coating technologies have helped enable the operational temperature limits of modem gas turbine engine ("GTE") components to be increased by several hundred degrees Fahrenheit within the past few decades. High temperature coatings formed over GTE components to provide resistance from chemical degradation are commonly referred to as environmental barrier coatings or, more simply, "EBCs." High temperature coatings formed over GTE components to reduce thermal transfer to the underlying substrate or parent material are commonly referred to as thermal barrier coatings or "TBCs." In many cases, one or more high temperature coatings (e.g., a TBC top coat) are combined with one or more additional coating layers (e.g., an underlying bond coat and an intervening oxide layer) to produce a multi-layer coating system.

Amongst other known deposition techniques (e.g., plasma spraying and other vapor deposition techniques), electron beam physical vapor deposition ("EB-PVD") has long been a preferred method for forming a high temperature coatings over GTE components. During a common EB-PVD process, an ingot is positioned within a crucible inside a vapor deposition chamber. A vacuum is drawn in the vapor deposition chamber, and the ingot is impinged with an electron beam to melt the uppermost portion of the ingot into a molten bath or pool held by the crucible. Due to the low pressure within the vapor deposition chamber and the elevated temperature of the pool, the ingot constituents gradually vaporize to form a vapor cloud or stream above the ingot. The vapors condense onto one or more surfaces of a GTE component, which is suspended in the vapor stream and temperature controlled. The ingot is slowly fed upward into the molten pool to continually consume the ingot material and to maintain a desired pool depth as the high temperature coating accumulates over the GTE component.

It is generally desirable for an EB-PVD process to yield a high temperature coating having a composition identical to that of the ingot. However, in instances wherein the ingot is composed of a complex alloy containing multiple constituents having different vaporization temperatures, undesirable variations between the coating composition and ingot composition may occur due to preferential vaporization of the ingot's metallic constituents. More specifically, when the melt temperature of the ingot is less than the individual vaporization temperatures of the ingot's metallic constituents under the sub-atmospheric pressures created within the vaporization chamber, the ingot's metallic constituents will vaporize at different rates with the metal having the lowest vaporization temperature vaporizing most rapidly, the metal having the second lowest vaporization temperature vaporizing at the second most rapid rate, and so on. Not only does this result in undesired variations between the coating composition and the ingot composition, this also results in variations in the vapor cloud and, therefore, results in variations in the deposited coating chemistry and associated deposition rates. While it is possible to simultaneously vaporize multiple ingots utilizing multiple electron beams to more closely control the final coating composition, such a solution adds undesired complexity and cost to the EB-PVD process.

It is thus desirable to provide embodiments of a method for vapor depositing high temperature coatings on gas turbine engine components in an efficient and low cost manner. It is particularly desirable to provide embodiments of a method for depositing high temperature coatings on gas turbine engine components by vaporizing a complex alloy ingot (e.g., an MCrAlY ingot wherein M is nickel, cobalt, or a combination thereof) utilizing a EB-PVD process wherein the final composition of the vapor-deposited coating is highly controllable and, in preferred implementations, substantially identical to the initial composition of the ingot. Other desirable features and characteristics of embodiments of the present invention will become apparent from the subsequent Detailed Description and the appended Claims, taken in conjunction with the accompanying drawings and the foregoing Background.

### BRIEF SUMMARY

Methods for vapor depositing high temperature coatings on gas turbine components are provided. In one embodiment, the method includes the step of producing a pre-alloyed puck including a master alloy and a high vaporization temperature refractory metal, which has a vaporization temperature greater than each of the master alloy constituents. The pre-alloyed puck is placed over an ingot and heated to a temperature greater than the melt point of the pre-alloyed puck and less than the vaporization temperature of the high vaporization temperature refractory metal to transform the puck and a portion of the ingot into a molten pool and to produce a vapor stream containing the constituents of the master alloy and the ingot. The vapor stream is exposed to a gas turbine engine component to deposit the high temperature coating over at least one surface thereof.

Further provided are methods for producing pre-alloyed pucks for usage in an electron beam vapor deposition process wherein the pre-alloyed puck is vaporized in conjunction with an ingot to deposit a high temperature coating over a substrate, such as a gas turbine engine component. In one embodiment, the method includes the step of producing a pre-alloyed material from at least a master alloy having a composition substantially identical to that of the ingot, and a high vaporization temperature refractory metal having a vaporization temperature greater than each of the master alloy constituents. The method further includes the step of forming the pre-alloyed material into the pre-alloyed puck.

### BRIEF DESCRIPTION OF THE DRAWING

At least one example of the present invention will hereinafter be described in conjunction with the following figure, wherein like numerals denote like elements, and:

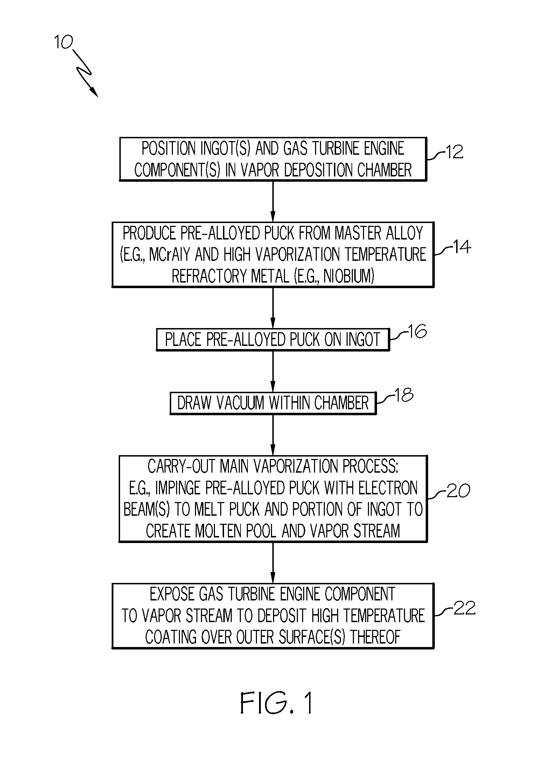

FIG. 1 is a flowchart illustrating a method for vapor depositing a high temperature coating over at least one surface of a gas turbine engine component in accordance with an exemplary and non-limiting embodiment of the present invention.

### DETAILED DESCRIPTION

The following Detailed Description is merely exemplary in nature and is not intended to limit the invention or the application and uses of the invention. Furthermore, there is no intention to be bound by any theory presented in the preceding Background or the following Detailed Description.

As described in the foregoing section entitled "BACKGROUND," when an EB-PVD process is utilized to vaporize a complex alloy ingot containing multiple metallic constituents (e.g., chromium, aluminum, yttrium, cobalt and/or nickel, etc.) having different vaporization temperatures, the ingot constituents will often vaporize at different rates thereby producing undesired variations between the ingot composition and the vapor-deposited coating composition. To address this issue, one or more refractory nuggets may be placed upon the ingot and then impinged with an electron beam to transform the nugget or nuggets to a molten state and to create a molten zone within the ingot. By adding a refractory element to the pool in this manner, the temperature of the molten pool can be increased to a level exceeding the respective vapor temperatures of the ingot metallic constituents at the sub-atmospheric pressures within the vapor deposition chamber. The ingot constituents will thus vaporize from the molten pool at equivalent or near equivalent rates to form a vapor cloud or stream above the molten pool having essentially the same composition as does the ingot. This, in turn, allows the deposition of a high temperature coating having a vapor cloud whose final composition is substantially identical to the ingot composition and substantially uniform through the coating's thickness. However, while enabling the formation of a vapor-deposited coating having a composition substantially identical to that of a complex alloy ingot, the above-described modified EB-PVD method is limited in certain respects. For example, it may be required to add the refractory nuggets to the pool periodically during an initial start-up phase to achieve a desired pool chemistry before the production phase of the vapor deposition process commences. This adds undesired delay, cost, and overall inefficiency to the EB-PVD process.

To overcome the above-described limitations, the following describes exemplary embodiments of a highly efficient EB-PVD process wherein a discrete mass of material composed of a master alloy pre-alloyed with at least one refractory metal (referred to below as a "pre-alloyed puck"). The refractory metal is chosen to have a vaporization temperature exceeding the vaporization temperature of each of the constituents included within the master alloy and is consequently referred to herein as a "high vaporization temperature refractory metal." Additionally, in view of its refractory nature, the high vaporization temperature refractory metal has relatively high melt point and, when combined with the master alloy, increases the melt point of the pre-alloyed puck. The pre-alloyed puck is placed upon or otherwise positioned over the ingot and heated to a predetermined process temperature, which is greater than the melt point of the puck and less than the vaporization temperature of the high vaporization temperature refractory metal. This transforms the pre-alloyed puck and an adjacent portion of the ingot into a molten pool and further produces a vapor stream containing the master alloy constituents and the ingot constituents. The vapor stream is then exposed to a gas turbine engine component to deposit the high temperature coating over at least one surface thereof.

FIG. 1 is a flowchart setting-forth a method **10** for vapor depositing a high temperature coating on a gas turbine engine ("GTE") component, as illustrated in accordance with an exemplary and non-limiting embodiment of the present invention. For ease of explanation, the following will primarily describe exemplary scenarios wherein the EB-PVD process is utilized to form a high temperature coating over a single GTE component by vaporizing a single pre-alloyed puck positioned over a single ingot; however, it will be appreciated that alternative embodiment of the EB-PVD process can be carried-out utilizing multiple pre-alloyed pucks positioned over one or more ingots to form a vapor-deposited coating over any practical number of GTE components. It should further be understood that the steps illustrated in FIG. 1 and described below are provided by way of example only; and that in alternative embodiments of method **10,** additional steps may be performed, certain steps may be omitted, and/or the steps may be performed in alterative sequences.

Exemplary method **10** commences with the step of positioning at least one ingot and at least one gas turbine engine component in a vapor deposition chamber (STEP **12,** FIG. 1). The ingot is composed of multiple metallic constituents and is preferably composed of a relatively complex alloy, such as a cobalt- or nickel-based superalloy. The composition of the ingot will vary depending upon the desired properties of the high temperature coating to be deposited over GTE component. The ingot may be purchased from a supplier or independently fabricated by, for example, melting chunks or pellets of the ingot's constituents in a crucible to create a molten alloy, which is then poured into a casting mold defining the ingot shape after fine tuning and verifying that the appropriate chemistry has been achieved. Although by no means limited to a particular shape or dimension, the ingot will often assume the form of an elongated cylinder having a predetermined diameter and length; e.g., as one example, an elongated cylindrical ingot may be produced having a diameter of about 3 inches (about 7.62 centimeters) and a length of about 24 inches (about 60.96 centimeters). After casting, the ingot may be subject to hot isostatic pressing and analyzed to ensure proper composition and homogeneity. The ingot may be positioned within vapor deposition chamber such that an upper portion of the ingot projects upward into a crucible, such as a water-cooled copper container, while the remainder of the ingot is disposed beneath the crucible and can be fed upward for consumption during the vaporization process.

In a preferred embodiments, the ingot contains, and ideally consists essentially of, an MCrAlY alloy. As appearing herein, the term "MCrAlY alloy" denotes an alloy predominately composed of its named constituents, namely, chromium, aluminum, yttrium, and "M," wherein M represents nickel, cobalt, or a combination thereof. The MCrAlY alloy can include lesser amounts of one or more additional metallic or non-metallic constituents, which may be added as a powder or other form to a base alloy during processing to optimize desired metallurgical properties, such as oxidation and corrosion resistance, of the resulting MCrAlY alloy. In one embodiment, the ingot comprises, and preferably consists entirely of, an MCrAlYX alloy wherein X is selected from the group consisting of hafnium, rhenium, ruthenium, platinum, palladium, silicon, tantalum, titanium, lanthanum, cerium, zirconium, and combinations thereof. In another embodiment, the ingot comprises an MCrAlY alloy and is essentially free of titanium. As appearing herein, the term "essentially free" denotes a content of less than about 1 percent by weight ("wt%") of a named element or material.

The GTE component positioned within the vapor deposition chamber during STEP **12** (FIG. 1) can be any component utilized within a gas turbine engine over which it is desirable to form a high temperature coating or coating system. The GTE component will typically be a hot section component positioned within the gas path of the gas turbine engine and disposed within or downstream of the engine's combustion section. A non-exhaustive list of hot section GTE components over which the high temperature coating may be formed includes combustor liners, turbine seals, turbine blades, compressor blades, nozzle guide vanes, duct members, and the like. As a specific example, the GTE component may be a fully-bladed turbine disk or compressor disk. The surface or surfaces of the GTE component over which the high temperature coating is to be vapor-deposited may be treated prior to or after positioning of the GTE component with the vapor deposition chamber. For example, one or more surfaces of the GTE component may be cleaned (e.g., treated with a degreasing agent), planarized (e.g., via lapping, grinding, or chemical-mechanical planarization), and/or otherwise prepared for the subsequent formation of the vapor-deposited coating. The GTE component may be newly-fabricated or service-run and requiring repair.

The high temperature coating formed pursuant to exemplary method **10** can be any coating or coating layer suitable for employment within a gas turbine engine environment, whether for thermal insulation, environmental stability, or another purpose. In many cases, the high temperature coating may serve as a thermal barrier coating or an environmental barrier coating. Furthermore, the high temperature coating can also be any layer included within a multi-layer coating system formed over a gas turbine component and amenable to formation via vapor deposition. For example, when included within a multi-layer coating system, the high temperature coating may be the final layer (e.g., a TBC top coat) included within the coating system or an intermediate layer (e.g., a bond coat) included within the coating system over which additional coatings layers are subsequently formed.

Prior to or after positioning the ingot and GTE component within the vapor deposition chamber (STEP **12,** FIG. 1), a pre-alloyed puck is produced comprising a master alloy and at least one high vaporization temperature refractory metal (STEP **14,** FIG. 1). As indicated above, the term "high vaporization temperature refractory metal" or, more simply, "HVT refractory metal" denotes a refractory metal having a vaporization temperature exceeding the vaporization temperatures of each of the constituents included within the master alloy and, preferably, each of the constituents included within the ingot. In one embodiment, the pre-alloyed puck consists essentially of the master alloy and a single HVT refractory metal. Although this need not always be the case, the composition of the master alloy is preferably substantially identical to the composition of the ingot material; that is, the composition of the master alloy and the composition of the ingot preferably differ by no more than about 1 wt% on a constituent-by-constituent basis. Thus, in embodiments wherein the ingot is composed of an MCrAlY alloy, such an MCrAlYX alloy of the type described above, the master alloy may likewise be composed of the same or a substantially identical MCrAlY alloy.

As appearing herein, the term "pre-alloyed puck" denotes a discrete mass or body of material containing or consisting essentially of a master alloy and at least one HVT refractory metal, as previously defined. The word "puck," in particular, is utilized in a broad sense to indicate that the discrete mass of pre-alloyed material is smaller in size than is the ingot and will typically (although not necessarily) have a generally rounded shape. In most cases, the puck will have a generally cylindrical or disk-like shape, although various other geometries are possible including tubular and spherical shapes. In embodiments wherein the puck has a generally rounded outer circumference, the outer diameter of puck is advantageously fabricated to be slightly less than the outer diameter of the ingot. For example, in an embodiment wherein the ingot has an outer diameter of about 3 inches (about 7.62 centimeters), the puck may be fabricated to have an outer diameter of about 2.75 inches (about 6.985 centimeters). The length of the puck, as taken axially through the body of the puck, will typically be a fraction of the length of the ingot. In the context of the relevant industry, the "puck" may also be referred to as an "egg" or an "add."

The primary purpose of the HVT refractory metal is to elevate the melt point of the pre-alloyed puck to ensure that, when the pre-alloyed puck melts along with a neighboring portion of the ingot, the vaporization temperatures of the constituents of the master alloy and ingot material have been surpassed, as considered under the sub-atmospheric chamber pressure. The candidate refractory metals for usage as the HVT refractory metal will vary in conjunction with the composition of the master alloy and the ingot material. In general, the HVT refractory metals suitable for this purpose may include, but are not limited to, titanium, vanadium, zirconium, niobium, molybdenum, ruthenium, rhodium, hafnium, tantalum, tungsten, rhenium, osmium, and iridium. A preferred sub-set of this group consists of niobium, molybdenum, tantalum, tungsten, rhenium, and hafnium. It is also desirable for the selected HVT refractory metal to be commercially available at lower costs and to have only a moderately-high melt temperature to reduce the time and energy required to reduce the pre-alloyed puck to a molten pool. For at least these reasons, niobium will be selected as the HVT refractory metal in many cases. However, in embodiments wherein the master alloy contains an element having a melt point exceeding that of niobium, a different refractory metal may be chosen for usage as the HVT refractory metal. For example, in implementations wherein the master alloy contains tantalum, tungsten may be utilized as the HVT refractory metal.

The amount of the HVT refractory metal contained within the pre-alloyed puck will vary amongst different embodiments. However, by way of non-limiting example, the pre-alloyed puck may be fabricated to include between about 10 wt% to about 50 wt% of the HVT refractory metal and, more preferably, between about 15 wt% to about 30 wt% of the HVT refractory metal. In one specific implementation wherein the pre-alloyed puck is fabricated from the same MCrAlY alloy utilized to fabricated the ingot, the pre-alloyed puck contains between about 10 wt% to about 50 wt% niobium, more preferably between about 15 wt% to about 30 wt% niobium, and still more preferably about 24±1 wt% niobium.

The pre-alloyed puck may be purchased from a supplier or independently fabricated. Fabrication of the puck is advantageously carried-out by first producing a pre-alloyed material including: (i) a master alloy, which may have a composition substantially identical to that of the complex alloy ingot (e.g., the ingot and master alloy may each be composed of an MCrAlY of the type described above); and (ii) a HVT refractory metal having a vaporization temperature greater than each of the master alloy constituents. After production, the pre-alloyed material is formed or shaped into the pre-alloyed puck. For example, the master alloy and the HVT refractory metal may be melted to produce a molten pre-alloyed material, which is then poured into a mold to defining the shape of the pre-alloyed puck. In this case, melting of the master alloy and HVT refractory metal is conveniently carried-out by vacuum induction melting, arc melting, or electron beam melting. Alternatively, the pre-alloyed puck can be fabricated utilizing powder metallurgy. In this latter case, metallic powders containing or consisting of the master alloy constituents and the high vaporization temperature refractory metal may first be mixed and subsequently sintered together to produce the pre-alloyed puck.

The pre-alloyed puck is next positioned over the ingot, while the puck and ingot remain in their solid states (STEP **16,** FIG. 1). The pre-alloyed puck may be placed or set directly on top of the ingot such that the puck is in intimate contact with the ingot's upper surface exposed through the crucible. In certain cases, the pre-alloyed puck may be fractured or otherwise separated into multiple pieces before placement upon the ingot. After placement of the pre-alloyed puck on the ingot, the vapor deposition chamber is evacuated to create a partial vacuum therein and to reduce the amount of oxygen and nitrogen within the chamber, which could otherwise interfere with vapor deposition of the high temperature coating (STEP **18,** FIG. 1). In preferred embodiment, an inert gas, such as argon, is further supplied to vapor deposition chamber to increase the pressure chamber by a predetermined amount after chamber evacuation; argon may be pumped into the vapor deposition chamber post evacuation. Higher chamber pressures tend to increase process efficiencies; e.g., higher collection rates and higher deposition rates may be achieved due to an increase in carrier gas density. In addition, higher chamber pressures tend to diffuse the electron beam and facilitate the distribution of energy. The selected chamber pressure will depend upon a variety of factors and will vary amongst different embodiments; however, by way of non-limiting example, the vapor deposition chamber may be pressure controlled to a predetermined chamber pressure ranging from about 0.05 to about 0.0005 pascal (about 5 x 10⁻³ mbar to about 5 x 10⁻⁶ mbar). Pressure fluctuations may result in undesired variances in the temperature and heating uniformity of (energy distribution across) the molten pool. For at least this reason, the pressure within the vapor deposition chamber is preferably held substantially constant or stable during the vapor deposition process. In one embodiment, the chamber pressure may be maintained within a relatively narrow range during the EB-PVD process; e.g., the chamber pressure may be controlled to differ by no more than about ±6 x 10⁻⁴ mbar and, more preferably, about ±2 x 10⁻⁴ mbar relative to selected chamber pressure during the vapor deposition process.

Next, at STEP **20** (FIG. 1), the main vaporization process is carried-out during which the pre-alloyed puck is impinged with at least one electron beam emitted from an electron beam generator to heat the puck to a predetermined temperature. The predetermined temperature is greater than the melt point of the puck and less than the vaporization temperature of the HVT refractory metal; e.g., in one embodiment wherein the master alloy and ingot are composed of an MCrAlY alloy, and wherein the HVT refractory metal is niobium, the puck (in particular, the molten pool produced by melting of the puck) may be heated to a temperature between about 1910°C and about 3422°C. As the pre-alloyed puck is heated to beyond its melt point, the pre-alloyed puck and a neighboring portion of the ingot, which has a melt point less than the pre-alloyed puck, are transformed into a molten pool. As the melt point of the pre-alloyed puck is higher than the vaporization temperatures of the constituents of the master alloy and ingot material at the sub-atmospheric chamber pressure, the ingot and master alloy constituents vaporize at equivalent or near equivalent rates to produce a vapor cloud or stream above the molten pool. The temperature to which the molten pool is heated is less than the vaporization temperature of the HVT refractory metal under process conditions; consequently, the vapor stream will contain only trace amounts of the HVT refractory metal, if any.

During the above-described vapor deposition process, the first electron beam may be moved across the surface of the molten pool in accordance with a predetermined movement pattern utilizing, for example, an electromagnetic control technique to improve uniformity of energy distribution and provide substantially even heating across the molten pool surface. Furthermore, in certain embodiments, the ingot may be simultaneously heated by impingement with at least a second electron beam for the purpose of uniformly distributing the power across the pool surface continuously or intermittently (commonly referred to as a "jumping beam") to compensate for the heat losses due to radiation and conduction to the water-cooled crucible containing the molten pool. By utilizing multiple electron beams or by moving a single beam over the pool such that the pool temperature is substantially uniform across the pool surface, by maintaining a stable pressure within the chamber in the above-described manner, and by controlling other process parameters (e.g., electron beam power and the ingot feed rate), process coating time can be held substantially constant to yield predictable coating thicknesses across multiple iterations of the EB-PVD process.

The vapor cloud or stream formed above the molten pool envelops the temperature controlled GTE component. Exposure of the GTE component to this vapor stream thus allows the vapor to condense onto the component's temperature controlled surface or surfaces, which gradually accumulates to form the desired high temperature coating thickness thereon (STEP 22, FIG. 1). The GTE component, and specifically the surfaces of the component over which the high temperature coating are deposited, are preferably temperature controlled to maintain the surfaces at a temperature below that of the vapor cloud utilizing, for example, an array of thermocouples. During the vaporization process, the bulk of the ingot remaining in a solid state is slowly transported into the molten pool (e.g., fed upward by one or more ingot feeders) to gradually consume the ingot material and to maintain a desired pool depth. The vapor stream formed over molten pool will typically decrease in density when moving outward away from the pool center; thus, to help ensure that a substantially uniform coating is formed over the GTE component, the GTE component may be moved through the vapor stream. For example, when the GTE component assumes the form of a bladed compressor or turbine disk, the GTE component may be continually rotated through the vapor cloud during the EB-PVD process. As the vapor cloud or stream formed above the molten pool has essentially the same composition as does the ingot and master alloy combination, the vapor-deposited coating will have final composition that is substantially identical to that of the ingot and master alloy combination. Thus, in embodiments wherein ingot and master alloy share the same formulation, the vapor-deposited coating formed pursuant to the above-described method will have essentially the same formulation as does the ingot. Furthermore, as the vapor stream contains little to no trace of the HVT refractory metal, the vapor-deposited coating will likewise be essentially free (i.e., contain less than 1 wt%) of the high vaporization temperature refractory metal.

The foregoing has thus provided embodiments of a method for vapor depositing high temperature coatings on gas turbine engine components in an efficient and low cost manner by utilizing a discrete mass of a high melt point material, namely, the above-described pre-alloyed puck, to raise the temperature of the molten pool created pursuant to the EB-PVD process. Notably, the above-described vapor-deposition methods for depositing high temperature allow vaporization of a complex alloy ingot (e.g., an MCrAlY ingot) utilizing a EB-PVD process wherein the final composition of the vapor-deposited coating is highly controllable and, in preferred implementations, substantially identical to the initial composition of the ingot. The above-described vapor-deposition methods also provide improved efficiency and lower energy demands as compared to EB-PVD methods wherein chunks of pure refractory metals are repeatedly added to the solidified pool created by melting complex alloy ingot in the conventionally-known manner.

Although primarily described above in the context of a larger exemplary EB-PVD process, the foregoing has also provided method for producing pre-alloyed pucks for usage in an EB-PVD process wherein the pre-alloyed puck is vaporized in conjunction with an ingot to deposit a high temperature coating over the body of a gas turbine engine component or other substrate. In the above-described embodiment, the method included the step of producing a pre-alloyed material from at least a master alloy having a composition substantially identical to that of the ingot, and a high vaporization temperature refractory metal having a vaporization temperature greater than each of the master alloy constituents. The method further included the step of forming the pre-alloyed material into the pre-alloyed puck. In one embodiment, the constituents of the master alloy are mixed with about 10 wt% to about 50 wt% niobium, and preferably about 15 wt% to about 30 wt% niobium, to produce the pre-alloyed material.

While at least one exemplary embodiment has been presented in the foregoing Detailed Description, it should be appreciated that a vast number of variations exist. It should also be appreciated that the exemplary embodiment or exemplary embodiments are only examples, and are not intended to limit the scope, applicability, or configuration of the invention in any way. Rather, the foregoing Detailed Description will provide those skilled in the art with a convenient road map for implementing an exemplary embodiment of the invention. It being understood that various changes may be made in the function and arrangement of elements described in an exemplary embodiment without departing from the scope of the invention as set-forth in the appended claims.

## Claims

1. A method (10) for vapor depositing a high temperature coating on a gas turbine component, the method (10) comprising:
producing (14) a pre-alloyed puck comprising a master alloy and a high vaporization temperature refractory metal, the high vaporization temperature refractory metal having a vaporization temperature greater than each of the master alloy constituents;
placing (16) the pre-alloyed puck over an ingot;
heating (20) the pre-alloyed puck to a temperature greater than the melt point of the pre-alloyed puck and less than the vaporization temperature of the high vaporization temperature refractory metal to transform the pre-alloyed puck and a portion of the ingot into a molten pool and a vapor stream comprising the constituents of the master alloy and the ingot; and
exposing (22) the vapor stream to a gas turbine engine component to deposit the high temperature coating onto at least one surface thereof.

2. A method (10) according to Claim 1 wherein the step of producing (14) comprises selecting the high vaporization temperature refractory metal from the group consisting of niobium, molybdenum, tantalum, tungsten, rhenium, and hafnium.

3. A method (10) according to Claim 2 wherein the step of producing (14) comprises producing the pre-alloyed puck to contain about 15 to about 30 weight percent of the high vaporization temperature refractory metal.

4. A method (10) according to Claim 2 wherein the step of producing (14) comprises producing a pre-alloyed puck comprising a master alloy and niobium.

5. A method (10) according to Claim 1 wherein the step of producing (14) comprises producing a pre-alloyed puck comprising an MCrAlY alloy and a high vaporization temperature refractory metal, wherein M is selected from the group consisting of cobalt, nickel, and combinations thereof.

6. A method (10) according to Claim 5 wherein the step of placing (16) comprises placing the pre-alloyed puck on an ingot comprising the MCrAlY alloy from which the pre-alloyed puck is fabricated.

7. A method (10) according to Claim 1 wherein the step of heating (20) comprises impinging the pre-alloyed puck with a first electron beam to heat the pre-alloyed puck to a temperature greater than the melt point of the pre-alloyed puck and less than the vaporization temperature of the high vaporization temperature refractory metal.

8. A method (10) according to Claim 7 further comprising the step of simultaneously heating (20) the ingot in conjunction with the pre-alloyed puck by impinging the ingot with a second electron beam.

9. A method (10) according to Claim 1 wherein the pre-alloyed puck is produced (14) utilizing a process selected from the group consisting of:
a first process, comprising:
melting the master alloy and the high vaporization temperature refractory metal to produce a molten pre-alloyed material utilizing one of the group consisting of vacuum induction melting, arc melting, and electron beam melting; and
pouring the molten pre-alloyed material into a mold to defining the shape of the pre-alloyed puck; and
a second process, comprising:
mixing metallic powders comprising the constituents of the master alloy and the high vaporization temperature refractory metal; and
sintering the mixed metallic powders to produce the pre-alloyed puck.

10. A method (10) according to Claim 1 wherein the step of producing (14) comprises producing the pre-alloyed puck from: (i) a master alloy comprising tantalum, and (ii) a high vaporization temperature refractory metal having a vaporization temperature greater than that of tantalum.
